Europäisches Patentamt

European Patent Office

Office européen des brevets

(11) Veröffentlichungsnummer: **0 482 553 A2**

## EUROPÄISCHE PATENTANMELDUNG

(21) Anmeldenummer: **91117919.0**

(22) Anmeldetag: **21.10.91**

(51) Int. Cl.⁵: **G03B 41/00**

(30) Priorität: **22.10.90 DE 4033556**

(43) Veröffentlichungstag der Anmeldung:
**29.04.92 Patentblatt 92/18**

(84) Benannte Vertragsstaaten:
**AT BE CH DE FR GB IT LI LU NL**

(71) Anmelder: **Karl Süss KG Präzisionsgeräte für Wissenschaft und Industrie - GmbH & Co.**
**Schleissheimer Strasse 90 Postfach 1809**
**W-8046 Garching bei München(DE)**

(72) Erfinder: **Süss, Winfried, Dr. c/o Karl Süss KG-GMBH & Co.**
**Schleissheimer Strasse 90**
**W-8046 Garching(DE)**
Erfinder: **Kaiser, Paul c/o Karl Süss KG-GMBH & Co.**
**Schleissheimer Strasse 90**
**W-8046 Garching(DE)**

(74) Vertreter: **Vossius & Partner**
**Siebertstrasse 4 P.O. Box 86 07 67**
**W-8000 München 86(DE)**

(54) **Messanordnung für x,y,gamma-Koordinatentische.**

(57) Es wird eine interferentielle Meßanordnung beschrieben, bei der mittels inkrementaler Meßsysteme mit Phasengittern die Position eines x,y,φ-Koordinatentisches bei seiner Verschiebung in allen drei Richtungen gleichzeitig bestimmt wird. Die Erfindung gewährleistet über große Verschiebungslängen eine extrem hohe Positionsgenauigkeit ohne aufwendige Kompensation von Umgebungseinflüssen und gestattet variable Anwendungsmöglichkeiten.

Fig.3

Die Erfindung betrifft eine Meßanordnung für x,y,ϕ-Koordinatentische.Sie kann insbesondere in der Halbleitertechnologie und in der Koordinatenmeßtechnik zum Einsatz kommen.

In der Halbleitertechnologie werden x,y,ϕ-Koordinatentische zur Positionierung von Wafern und Masken durch Verschieben in x- und y-Richtung und Drehen um einen Winkel um die z-Achse verwendet. Dabei werden Auflösungen im Bereich unter 5 nm und Wiederholgenauigkeiten besser 30 nm erreicht.

Die Positionsmessung erfolgt im allgemeinen mittels Laserinterferometern. Die notwendigen Genauigkeiten lassen sich hierbei nur durch umfangreiche Kompensationsmaßnahmen für den Lichtweg erreichen, die einen beträchtlichen Platzbedarf haben. Insbesondere ist eine Abschirmung der Laserinterferometer gegen störende Umgebungseinflüsse durch Messen in einer Klimakammer erforderlich. Mit der Laserinterferometrie vergleichbare Genauigkeiten lassen sich isoliert in einer Achsrichtung nach einem interferentiellen Meßprinzip mittels inkrementaler Meßsysteme unter Verwendung von Phasengittern erreichen. Wird ein solches Meßsystem an einem Kreuztisch angebracht, so ermöglicht es die exakte Positionierung in einer Achse. Es werden aber keine Führungsfehler durch Abweichungen des Tisches rechtwinklig zur Meßrichtung erfaßt. Fehler durch Verdrehungen des Tisches bleiben gleichfalls unerkannt. Daher kann ein Koordinatentisch mittels des erwähnten inkrementalen Meßsystems auch durch Anordnung zweier Systeme in x- und y-Richtung nicht genau vermessen werden, da jeweils nur eine Achsrichtung vermessen wird und gleichzeitig ablaufende Veränderungen in der anderen Richtung nicht bemerkt werden.

Eine interferentielle Koordinatenmeßvorrichtung für Vergrößerungskopien ohne Laserinterferometer, die eine gleichzeitige Messung in zwei zueinander senkrechten Achsen und die Messung einer Drehung in der durch die Achsen definierten Ebene ermöglicht, ist aus der DE-PS-34 22 850 bekannt. Ein Koordinatentisch ist auf einer festen Unterlage angeordnet. Auf dem Koordinatentisch sind in zur Tischebene senkrechten Ebenen in x- und y-Richtung Beugungsgitter angeordnet, die sich mit dem Koordinatentisch bewegen. Mit der festen Unterlage verbunden sind hinter den Beugungsgittern Reflektoren und vor den Beugungsgittern Beleuchtungs- und Photoempfangseinrichtungen angeordnet, die, optisch gekoppelt, als Sensoren für das Auftreten von Interferenzstreifen in Abhängigkeit von der Bewegung der Beugungsgitter mit dem Tisch dienen. Die Drehung des Koordinatentisches wird über die Verschiebung zweier gegenüberliegender Beugungsgitter bestimmt. Über die Genauigkeit der Positionserfassung werden keine Angaben gemacht. Es wird nur darauf hingewiesen, daß die Verschiebungslänge des Tisches zwischen zwei Interferenzstreifen gleich einer vom Strichabstand des Beugungsgitters abhängigen Konstanten ist. Die robuste Ausführungsform der auf der Tischebene senkrecht stehenden Beugungsgitter sowie die makroskopische Ausbildung der Reflektoren sollten jedoch einer extremen Positioniergenauigkeit, wie sie sonst mit Laserinterferometern erreicht wird, entgegenstehen. Die Verschiebung des Tisches in x- und y-Richtung wird durch den Abstand der Reflektoren von den Beugungsgittern begrenzt, der für eine gebündelte Strahlführung nicht sehr groß gewählt werden kann. Des weiteren ist die aus der Tischebene nach oben herausragende Meßanordnung zu sperrig und speziell für den Fall der Vergrößerungskopie konstruiert. Die Koordinatenmeßvorrichtung ist daher für eine Verwendung in der Photolithographie bei der gegenseitigen Zuordnung von Maske und Wafer, bei der großflächig zwei Ebenen mit geringem Abstand über große Strecken gegeneinander verfahren werden müssen, ungeeignet.

Der Erfindung liegt die Aufgabe zugrunde, eine mit der Genauigkeit der Laserinterferometer vergleichbare Meßanordnung für x-y-ϕ-Koordinatentische zur Verfügung zu stellen, die kostengünstig sowie gegen Umgebungseinflüsse unempfindlich ist und eine einfache Tischkonstruktion ermöglicht.

Die Lösung dieser Aufgabe wird mit den Merkmalen der Patentansprüche erreicht.

Bei dieser Lösung liegt der Erfindung der Gedanke zugrunde, die die erforderliche Genauigkeit liefernden inkrementalen Meßsysteme mit Phasengittern und Sensoren in x,y-Richtungen anzuordnen, ständig die Verschiebung des Tisches mit beiden Meßsystemen zu messen und durch eine Aneinanderreihung von Sensoren und Übertragung der Meßwerte von Positionsspeicher zu Positionsspeicher eines über ein Phasengitter hinauslaufenden Sensors auf einen benachbarten Sensor eine Positionserfassung über große Verschiebungslängen des Koordinatentisches zu ermöglichen.

Diese Lösung ist als besonders vorteilhaft anzusehen, da die Zuordnung von Phasengittern und Sensoren zu den Verschiebungsobjekten variabel ist und entsprechend den Wünschen des Anwenders gewählt werden kann. Mit der Meßanordnung lassen sich Messungen über große Verschiebungslängen ausführen, die gegenüber Abstandsänderungen der Sensoren und der Gitter bezüglich des Koordinatentischmittelpunkts unempfindlich sind. Die erfindungsgemäße Meßanordnung ist besonders günstig, wenn z.B. ein Wafer unter einer Maske, wie z.B. bei Röntgensteppern in der Röntgenlithografie mehrfach verfahren werden soll. Es können auch fehlerhafte Abstandsänderungen der Phasengitter und der Sensoren bezüglich des Koordinatentischmittelpunkts erfaßt werden.

Die Erfindung wird nachstehend mit Bezug auf die Zeichnungen (nicht maßstabsgetreu) näher erläutert. Es zeigen:

Fig. 1　　einen Ausschnitt einer schematischen, perspektivischen Darstellung einer erfindungsgemäßen Ausführungsform in Meßposition,

Fig. 2　　einen Querschnitt längs der Linie A, B in Fig. 1,

Fig. 3　　eine schematische Darstellung einer erfindungsgemäßen Ausführungsform mit tangential angeordneten Phasengittern in der Meßposition,

Fig. 4　　eine schematische Darstellung einer erfindungsgemäßen Ausführungsform mit radial angeordneten Phasengittern in der Meßposition,

Fig. 5　　eine erfindungsgemäße Ausführungsform mit in der Ebene der ruhenden Maskenhalterung angeordneten Sensoren,

Fig. 6　　eine erfindungsgemäße Ausführungsform mit in der Ebene beweglichen Waferhalterung angeordneten Phasengittern;

Fig. 7　　die Anordnungen gemäß Fig. 5 und Fig. 6 in Meßposition,

Fig. 8　　eine erfindungsgemäße Ausführungsform mit in der Ebene der Maskenhalterung angeordneten Phasengittern,

Fig. 9　　eine erfindungsgemäße Ausführungsform mit in der Ebene der Waferhalterung angeordneten Sensoren,

Fig. 10　　eine erfindungsgemäße Ausführungsform mit zwei Sensorarmen,

Fig. 11　　eine erfindungsgemäße Ausführungsform mit zusätzlichen Sensoren zwischen zwei Meßpositionen, und

Fig. 12　　eine erfindungsgemäße Ausführungsform, wobei die Phasengitter als Kreuzgitter ausgebildet sind.

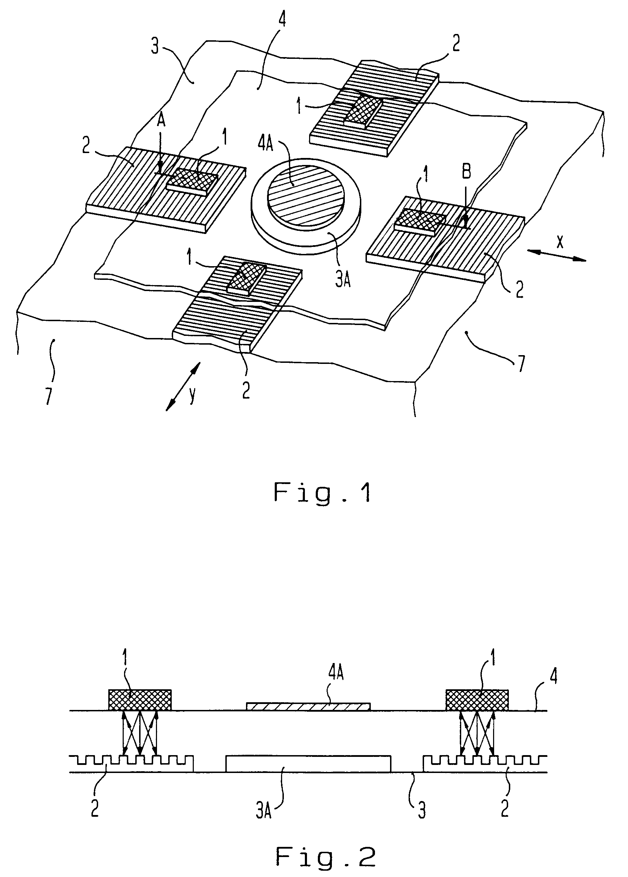

Fig. 1 zeigt eine Darstellung eines Ausschnittes des zentralen Teiles einer erfindundungsgemäßen Meßanordnung. Auf einem Koordinatentisch 7 sind in der Ebene 3 in x- und y-Richtung Phasengitter 2 sowie ein Wafer 3A angeordnet. Oberhalb und parallel zur Ebene 3 und von ihr gering beabstandet sind in der Ebene 4 Sensoren 1 und eine Maske 4A angeordnet. In der Zeichnung ist die Ebene 4 Bestandteil einer planparallelen Platte aus durchsichtigem Material. Die vergrößert dargestellten Phasengitter 2 haben Teilungsperioden (Striche) von kleiner 10 μm. Zur Vereinfachung ist in Fig. 1 und 2 je Phasengitter 2 nur ein Sensor 1 abgebildet. Die Sensoren 1 emittieren Licht, das an den Phasengittern 2 gebeugt und in Abhängigkeit von der relativen Verschiebung von Phasengitter 2 und Sensor 1 zur Interferenz gebracht wird. Die Intensität des in die Sensoren 1 zurückreflektierten Lichtes wird von ihnen registriert und dient als Maß für eine Relativbewegung von Maske 4A und Wafer 3A. Die Anordnung gemäß Fig. 1 sieht eine Bewegung des Koordinatentisches 7 in x-und y-Richtung gegenüber der Ebene 4, also eine Verschiebung des Wafers 3A und der Phasengitter 2 gegenüber der Maske 4A und den Sensoren 1, vor.

Fig. 2 zeigt im Querschnitt die Anordnung der Sensoren 1 und der Maske 4A oberhalb der Phasengitter 2 und des Wafers 3A in x-Richtung. Die Sensoren 1 stehen in optischem Eingriff mit den Phasengittern 2. Der Strahlengang des einfallenden und des gebeugten Lichtes ist vereinfacht dargestellt.

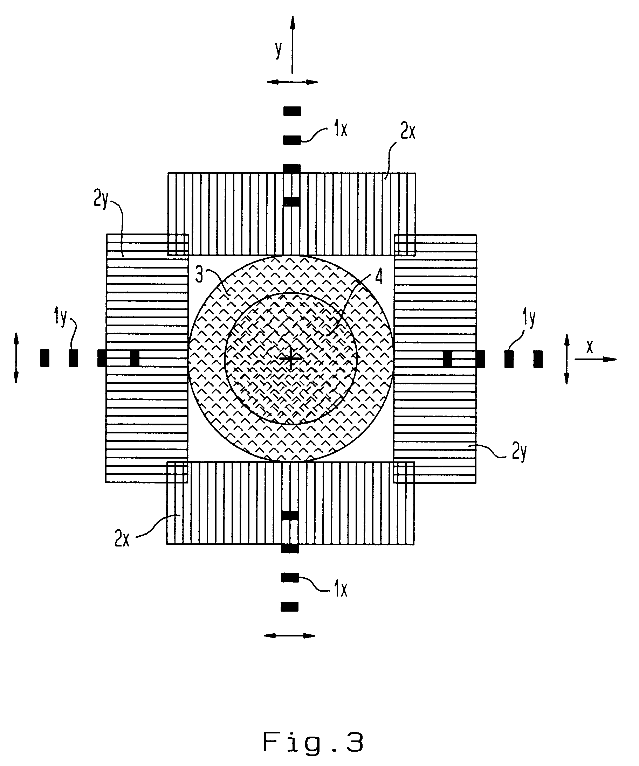

Fig. 3 stellt eine erfindungsgemäße Meßanordnung bei einem Koordinatentisch für die Photolithographie dar. Die Phasengitter 2x, 2y und die Sensoren 1x, 1y befinden sich in je einer von zwei parallelen Ebenen, wahlweise in der Ebene der Masken- oder Waferhalterung 4 bzw. 3. Vorzugsweise werden dabei die Phasengitter und/oder die Sensorebene durch eine entsprechende Vorrichtung genau in die Maskenebene 4A bzw. in die Waferebene 3A oder umgekehrt gelegt, um Abbé-Fehler zu vermeiden. Die Phasengitter 2x, 2y sind tangential und die Reihen der Sensoren 1x, 1y sind radial zum Koordinatentischmittelpunkt angeordnet. Die Sensoren 1x, 1y registrieren in Pfeilrichtung eine Verschiebung der Phasengitter 2x, 2y. Die Länge der Phasengitter 2x, 2y kann z.B. ≧ 220 mm sein. Die Breite der Phasengitter 2x, 2y und die Abstände der Sensoren 1x, 1y sind so bemessen, daß gleichzeitig mindestens zwei Sensoren 1x, 1y mit den Phasengittern 2x, 2y in einer Meßrichtung in Eingriff sind. Die tangentiale Anordnung der Phasengitter 2x, 2y ist eine bevorzugte Ausführungsform und besonders vorteilhaft, da auf diese Weise die Messung gegenüber fehlerhaften Abstandsänderungen der Sensoren 1x, 1y oder der Phasengitter 2x, 2y bezüglich des Koordinatentischmittelpunktes unempfindlich ist.

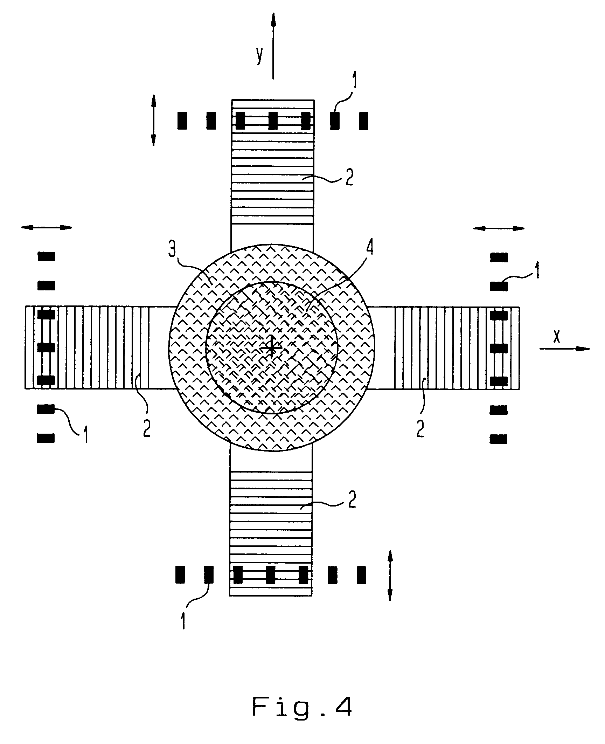

Fig. 4 zeigt eine Anordnung gemäß Fig. 3 mit Phasengittern 2, die radial, und Reihen von Sensoren 1, die tangential zum Koordinatentischmittelpunkt angeordnet sind. Mit dieser Meßanordnung können zusätzlich zum Verfahrweg Abstandsänderungen der Sensoren 1 bzw. der Phasengitter 2 bezüglich des Koordinatentischmittelpunktes erfaßt werden.

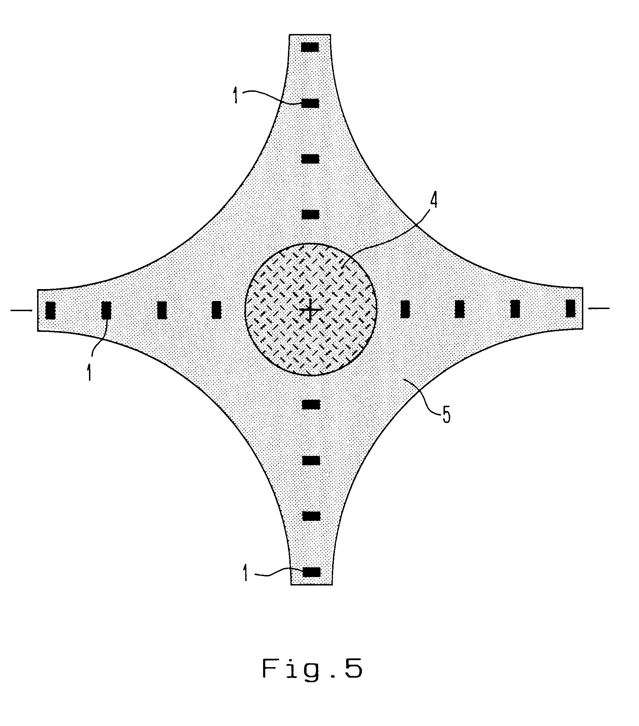

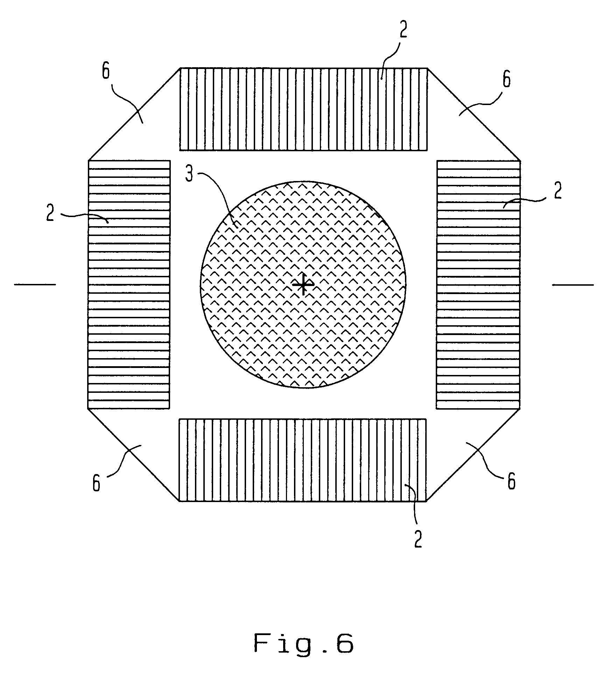

Fig. 5 zeigt eine erfindungsgemäße Ausführungsform, bei der die Sensoren 1 auf einem Träger 5 in der Ebene der Maskenhalterung 4 angeordnet sind, und in Fig. 6 sind die Phasengitter 2 auf einem Träger 6 in der Ebene der Waferhalterung 3 angeordnet.

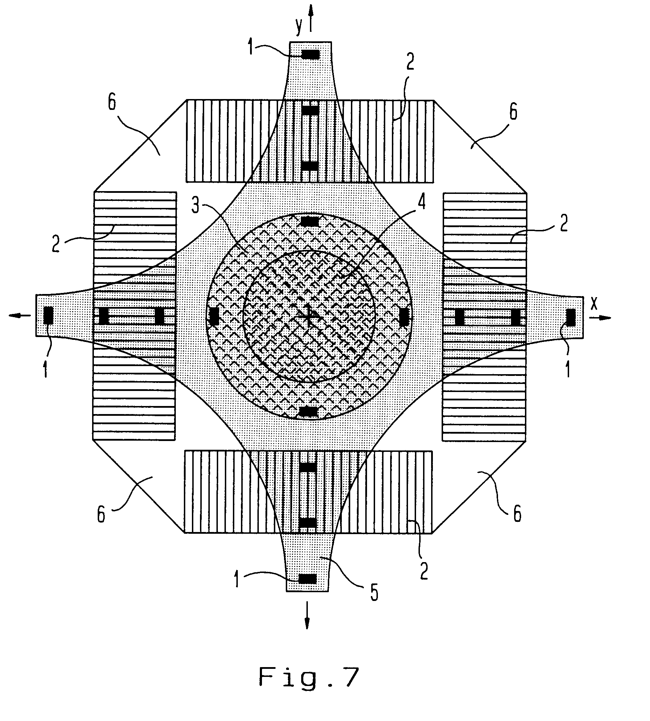

Fig. 7 zeigt die Zuordnung der beiden Anordnungen gemäß Fig. 5 und 6 beim Vermessen der gegenseitigen Relativbewegung.

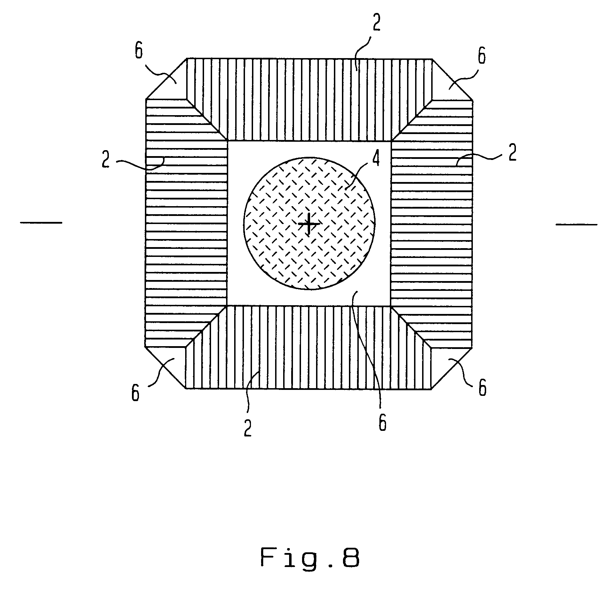

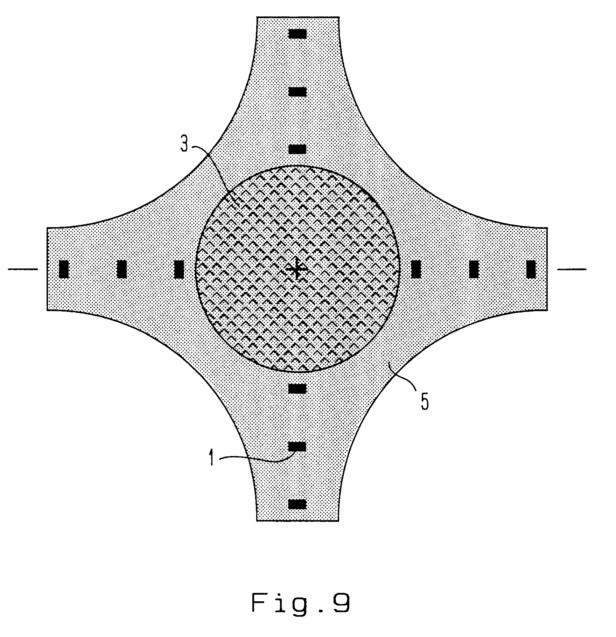

Fig. 8 stellt eine andere Variante bei der Anordnung der Phasengitter 2 dar. Dabei sind die Phasengitter 2 in der Ebene der Maskenhalterung 4 angeordnet. Umgekehrt sind dann, wie in Fig. 9 gezeigt wird, die Sensoren 1 in der Ebene der Waferhalterung 3 angeordnet.

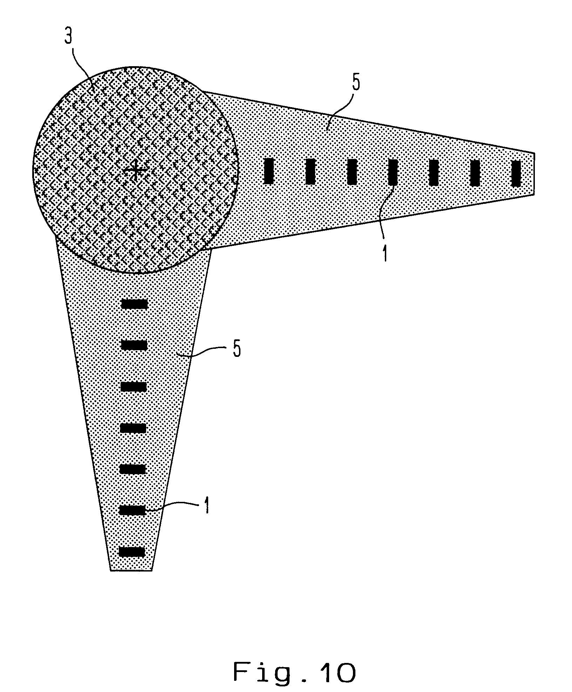

In einer weiteren erfindungsgemäßen Ausführungsform, dargestellt in Fig. 10, können auch nur zwei Reihen von Sensoren 1 mit entsprechenden Phasengittern 2 (nicht dargestellt) zum Einsatz kommen.

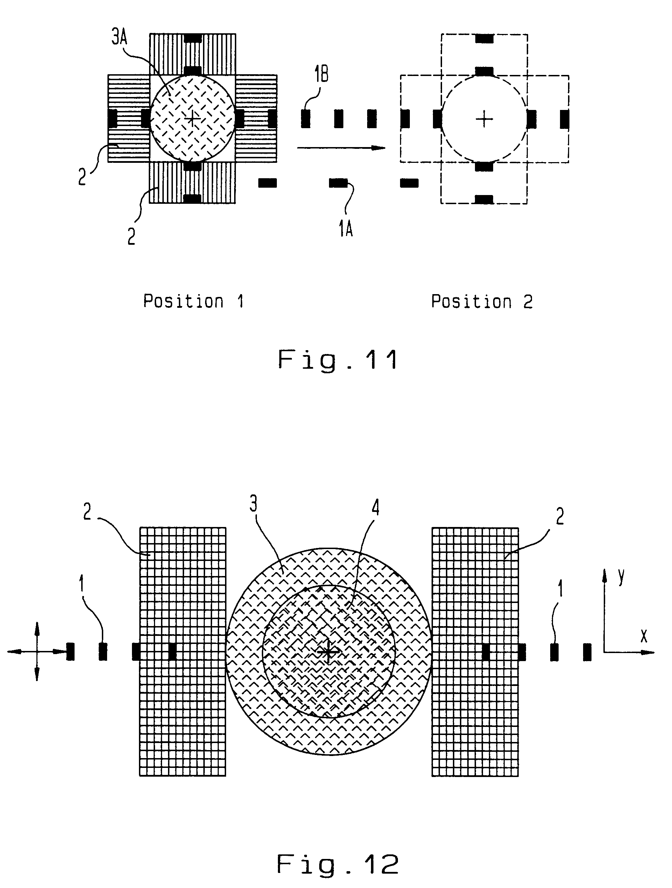

Fig. 11 zeigt eine weitere erfindungsgemäße Ausführungsform, bei der auf der Verschiebungsstrecke des Koordinatentisches zwischen zwei Meßpositionen 1, 2 der Meßanordnung mit einem Wafer 3A Sensoren 1A, 1B zusätzlich angeordnet sind. Dadurch wird eine ständige Überwachung der Verschiebung gewährleistet und eine sehr genaue Ansteuerung der Position 2 erreicht. Die erfindungsgemäße Ausführungsform kann z.B. bei einem Waferprober verwendet werden.

An Stelle der einachsigen Phasengitter gemäß Figuren 3 bis 11 können gemäß Fig. 12 auch zweiachsige Phasenkreuzgitter 2 verwendet werden, wobei zwei Strichgitter in einer Ebene zueinander rechtwinklig überlagert sind und eine Art Schachbrettmuster bilden. Dabei können für die Abtastung in x- und y-Richtung je ein Sensor 1 oder auch nur ein Sensor 1 für beide Richtungen vorgesehen sein.

Die erfindungsgemäße Meßanordnung kann mit kommerziellen inkrementalen Meßsystemen mit Phasengittermaßstäben mit einer Teilungsperiode < 10 $\mu$m und einer Länge von z.B. $\geq$ 220 mm, wie sie von der Firma Heidenhain GmbH, Traunreut, Deutschland hergestellt werden, aufgebaut werden. Temperatureinflüsse, die zur Veränderung der Dimensionen der Meßanordnung führen können, werden durch deren symmetrische Anordnung und die Verwendung von Materialien mit geringen Wärmeausdehnungskoeffizienten, vorzugsweise Glassorten, z.B. Cerodur minimiert. Teilungsfehler bei der Herstellung können softwaremäßig kompensiert werden. Dabei werden geringfügige, gezielte, relative Verkippungen der Maßstabebene zur Sensorebene miterfaßt.

Zur Positionsmessung mit der erfindungsgemäßen Meßanordnung werden beim Bewegen des Koordinatentisches die Sensoren 1 und die Phasengitter 2 gegeneinander bewegt. Dabei empfangen die Sensoren in beiden Koordinatenrichtungen gleichzeitig optische Signale, die ein Maß für die relative Positionsänderung der Phasengitter 2 und der Sensoren 1 darstellen. Bei der Verschiebung des Koordinatentisches z.B. in Fig. 3 in nur einer Richtung (z.B. in y-Richtung) wird diese nur durch die dieser Richtung zugeordneten Sensoren 1y (Reihen, ausgerichtet in x-Richtung), die sich längs eines Phasengitters 2y verschieben, registriert. Sensoren 1x (Reihen, ausgerichtet in y-Richtung), die sich senkrecht zur Längsrichtung eines Phasengitters verschieben, registrieren keine Positionsänderung. Diese Sensoren 1x erfassen aber jede seitliche Verschiebung (in x-Richtung) bei der Bewegung des Tisches in eine Richtung (y-Richtung), und überwachen so die ordnungsgemäße Führung des Koordinatentisches. Eine Drehung des Koordinatentisches in -Richtung läßt sich aus der Verschiebung der Sensoren in gegenüberliegenden oder in zwei nebeneinanderliegenden und um 90° versetzten Phasengittern bestimmen. Auch aus der Verschiebung zweier benachbarter Sensoren in einem einzigen Phasengitter läßt sich eine Drehung bestimmen. Um eine ständige Überwachung in beiden Koordinatenachsen zu gewährleisten, werden bei größeren Verschiebungslängen, wenn die Sensoren 1 in einer Richtung über die Breite des Phasengitters hinausfahren, die Positionsdaten des die Phasengitterfläche verlassenden Sensors 1 auf einen benachbarten Sensor 1, der mit dem Phasengitter in Eingriff steht, übertragen. Zum Beispiel werden in Fig. 3 beim Verschieben des Koordinatentisches in y-Richtung Sensoren 1x der oberen sich in y-Richtung erstreckenden Reihe aus dem ihnen zugeordneten Phasengitter 2x herausgefahren. Dabei werden die Positionsdaten aus dem Sensor-Positionsspeicher des über das Phasengitter 2x hinausfahrenden Sensors 1x vom Positionsspeicher des benachbarten Sensors 1x, der sich noch mit dem Phasengitter in Eingriff befindet, übernommen. Auf diese Weise wird die Breite des Phasengitters 2x ständig durch einen der Sensoren 1x einer Sensorreihe abgetastet, und es stehen ständig die Positionsdaten der gesamten Verschiebungslänge zur Verfügung. Das gleiche geschieht bei einer Verschiebung des Koordinatentisches in x-Richtung mit den Sensoren 1y der rechten Sensorreihe in Fig. 3.

Die Überwachung der Verschiebung der Meßanordnung von einer ersten Meßposition, Position 1, in eine zweite, Position 2, gemäß Fig. 11 erfolgt nach dem gleichen Prinzip wie die Messung selbst. Bei der Verschiebung z.B. des Wafers 3A mit den Phasengittern 2 in Pfeilrichtung kommen die Sensoren 1A mit dem horizontal angeordneten Phasengitter 2 in Eingriff und registrieren die Verschiebung. Gleichzeitig stellen die Sensoren 1B mittels der vertikal angeordneten Phasengitter 2 fest, ob eine Abweichung senkrecht zur Verschiebungsrichtung auftritt, so daß eine eventuelle Korrektur der Verschiebung erfolgen kann.

Die erfindungsgemäße Meßanordnung kann auch in Meßmaschinen oder Probergeräten zur Positionierung von Testsensoren z.B. Testnadeln bezüglich Halbleiterstrukturen verwendet werden.

Mit dem erfindungsgemäßen Verfahren lassen sich Wiederholgenauigkeiten von 10 nm oder besser erreichen.

## Patentansprüche

1. Meßanordnung für x,y,$\phi$-Koordinatentische, bestehend aus zwei zueinander beweglichen Trägern, mit
   a) Beugungsgittern (2) für die x- und y-Richtung,
   b) Sensoren (1) mit Lichtquellen und Empfangseinrichtungen zum gleichzeitigen optischen Abtasten der Beugungsgitter (2) in x- und y-Richtung zum Erzeugen optischer Signale,
   c) wobei die Beugungsgitter (2) und die Sensoren (1) auf dem ersten bzw. zweiten Träger angeordnet sind, und
   d) Einrichtungen zum Umwandeln der optischen Signale in Positionsanzeigen in x,y-Richtung und einen Drehwinkel $\phi$ um eine zur x,y-Ebene senkrechte Achse mit den Sensoren (1) zugeordneten Positionsspeichern,
   dadurch gekennzeichnet,
   e) daß die Beugungsgitter (2) als Phasengitter (2) ausgebildet sind,
   f) daß jedem Phasengitter (2) eine Reihe von Sensoren (1) zugeordnet ist, und
   g) daß gleichzeitig mindestens zwei Sensoren (1) mit jedem Phasengitter (2) in Eingriff bringbar sind,
   h) wobei die Positionsdaten der Messung in den den Sensoren (1) zugeordneten Positionsspeichern von Speicher zu Speicher übertragbar sind, so daß eine kontinuierliche Messung über große Längen in x- und y-Richtung durchführbar ist.

2. Meßanordnung nach Anspruch 1, dadurch gekennzeichnet, daß die Phasengitter (2) in einer gemeinsamen Ebene liegen.

3. Meßanordnung nach Anspruch 1 oder 2, dadurch gekennzeichnet, daß die Sensoren (1) in einer gemeinsamen Ebene liegen.

4. Meßanordnung nach Anspruch 2 oder 3, dadurch gekennzeichnet, daß die Ebenen der Phasengitter (2) und der Sensoren (1) parallel zueinander angeordnet sind.

5. Meßanordnung nach einem der Ansprüche 1 bis 4, dadurch gekennzeichnet, daß die Sensoren (1) rotationssymmetrisch zum Koordinatenmittelpunkt angeordnet sind.

6. Meßanordnung nach einem der Ansprüche 1 bis 5, dadurch gekennzeichnet, daß die Phasengitter (2) rotationssymmetrisch zum Koordinatenmittelpunkt angeordnet sind.

7. Meßanordnung nach einem der Ansprüche 1 bis 6, dadurch gekennzeichnet, daß die Phasengitter (2) hinsichtlich der Teilungsperioden tangential und die Sensorreihen (1) radial zum Koordinatentischmittelpunkt angeordnet sind.

8. Meßanordnung nach einem der Ansprüche 1 bis 6, dadurch gekennzeichnet, daß die Phasengitter (2) hinsichtlich der Teilungsperioden radial und die Sensorreihen (1) tangential zum Koordinatentischmittelpunkt angeordnet sind.

9. Meßanordnung nach einem der Ansprüche 1 bis 8, dadurch gekennzeichnet, daß die Sensoren (1) hintereinander und seitlich versetzt angeordnet sind.

10. Meßanordnung nach einem der Ansprüche 1 bis 8, dadurch gekennzeichnet, daS die Phasengitter (2) bzw. die Träger (5) für die Sensoren (1) als einstückige Platten (5, 6) ausgebildet sind.

11. Meßanordnung nach einem der Ansprüche 1 bis 10, dadurch gekennzeichnet, daß die Phasengitter (2) auf einem ruhenden Teil und die Sensoren (1) auf einem beweglichen Teil angeordnet sind.

12. Meßanordnung nach einem der Ansprüche 1 bis 10, dadurch gekennzeichnet, daß die Sensoren (1) auf einem ruhenden Teil und die Phasengitter (2) auf einem beweglichen Teil angeordnet sind.

13. Meßanordnung nach einem der Ansprüche 1 bis 10, dadurch gekennzeichnet, daß die Phasengitter (2) und die Sensoren (1) auf beweglichen Teilen angeordnet sind.

14. Meßanordnung nach einem der Ansprüche 1 bis 13, dadurch gekennzeichnet, daß die Phasengitter (2) und Sensoren (1) so weit außen angebracht werden, daß sie nicht über empfindliche Flächen, die sich innerhalb des Verfahrbereiches befinden, bewegbar sind.

15. Meßanordnung nach einem der Ansprüche 1 bis 14, dadurch gekennzeichnet, daß die Phasengitter (2) Phasengittermaßstäbe mit einer Teilungsperiode < 10 $\mu$m und einer Länge von ≧ 220 mm sind.

16. Meßanordnung nach einem der Ansprüche 1 bis 15, dadurch gekennzeichnet, daß auf der Strecke zwischen zwei Meßpositionen (Positionen 1, 2) zusätzliche Sensoren (1A, 1B) angeordnet sind.

17. Meßanordnung nach einem der Ansprüche 1 bis 16, dadurch gekennzeichnet, daß die Phasengitter (2) als Phasenkreuzgitter (2) ausgebildet sind, wobei die x- und y-Richtung gemeinsam durch einen Sensor (1) oder getrennt durch zwei Sensoren (1) abgetastet werden.

18. Verfahren zum Bestimmen der x-, y- und $\phi$ - Koordinaten eines Koordinatentisches mit der Meßanordnung nach einem der Ansprüche 1 bis 17, dadurch gekennzeichnet,

    a) daß die Phasengitter (2) und die Sensoren (1) beim Bewegen des Koordinatentisches gegeneinander verfahren werden,

    b) daß die Sensoren (1) in beiden Koordinatenrichtungen mittels der Phasengitter (2) gleichzeitig ein optisches Signal empfangen, das ein Maß für die relative Positionsänderung von Gittern (2) und Sensoren (1) darstellt,

    c) daß die Einrichtung zum Umwandeln der optischen Signale in Positionsanzeigen die Position in x- und y-Richtung und den Drehwinkel um eine zur x,y-Ebene senkrechte Achse bestimmt, und

    d) daß die Positionsdaten im Positionsspeicher eines über die Fläche eines Phasengitters (2) hinauslaufenden Sensors (1) vom Positionsspeicher eines benachbarten Sensors (1), der mit dem Phasengitter (2) in Eingriff steht, übernommen werden.

19. Verfahren nach Anspruch 18, dadurch gekennzeichnet, daß die Drehwinkelerfassung mittels gegenüberliegender Phasengitter (2) erfolgt.

20. Verfahren nach Anspruch 18, dadurch gekennzeichnet, daß die Drehwinkelerfassung mittels zweier nebeneinanderliegender, um 90° versetzter Phasengitter (2) erfolgt.

21. Verfahren nach Anspruch 18, dadurch gekennzeichnet, daß die Drehwinkelerfassung mittels zweier benachbarter Sensoren (1) und eines einzigen Phasengitters (2) erfolgt.

22. Verfahren nach einem der Ansprüche 18 bis 21, dadurch gekennzeichnet, daß bei der Messung Lichtquellen von Sensoren (1), die nicht zur Messung kommen ausgeschaltet werden.

23. Verfahren zur Überwachung einer Verschiebung der Meßanordnung nach Anspruch 16 von einer ersten Meßposition (Position 1) zu einer zweiten (Position 2), dadurch gekennzeichnet, daß mittels der Phasengitter (2) erste Sensoren (1A) die Verschiebung (Pfeilrichtung) und zweite Sensoren (1B) eine Abweichung senkrecht zur Verschiebungsrichtung registrieren.

24. Verwendung der Meßanordnung nach einem der Ansprüche 1 bis 17 bei einem Koordinatentisch für die Lithographie, insbesondere die Röntgenlithographie.

25. Verwendung nach Anspruch 24, dadurch gekennzeichnet, daß die Waferhalterung (3) in der Ebene der Phasengitter (2) und die Maskenhalterung (4) in der Ebene der Sensoren (1) angeordnet ist.

26. Verwendung nach Anspruch 24, dadurch gekennzeichnet, daß die Maskenhalterung (4) in der Ebene des Phasengitter (2) und die Waferhalterung (3) in der Ebene der Sensoren (1) angeordnet ist.

27. Verwendung der Meßanordnung nach einem der Ansprüche 1 bis 17 und 24 bis 26, dadurch gekennzeichnet, daß die Sensorebene genau in der Masken- bzw. Waferebene (4A) bzw. (3A) oder in der Ebene eines zu vermessenden Objekts liegt.

28. Verwendung der Meßanordnung nach einem der Ansprüche 1 bis 17 und 24 bis 26. dadurch gekennzeichnet, daß die Phasengitterebene genau in der Masken- bzw. Waferebene (4A) bzw. (3A) oder in der Ebene eines zu vermessenden Objekts liegt.

29. Verwendung der Meßanordnung nach einem Der Ansprüche 1 bis 17 und 24 bis 28 bei Meßmaschinen und Probergeräten zur Positionierung von Sensoren (1) bezüglich Halbleiterstrukturen.

Fig.1

Fig.2

Fig.3

Fig.4

Fig.5

Fig.6

Fig.7

Fig.8

Fig.9

Fig.10

Position 1                    Position 2

Fig. 11

Fig. 12

16